# EUROPEAN PATENT APPLICATION

(11) **EP 3 640 979 A1**
(43) Date of publication of application: **22.04.2020**
(21) Application number: 18200483.8
(22) Date of filing: 15.10.2018
(51) Int. Cl.: H01L 23/31, H01L 23/473, H01L 21/56, H01L 23/00

(54) **A METHOD FOR PACKAGING SEMICONDUCTOR DIES**

(71) Applicant: IMEC vzw, 3001 Leuven (BE)
(72) Inventor: Beyne, Eric, 3001 Leuven (BE)
(74) Representative: Patent Department IMEC

(57) **Abstract**

The invention is related to a method for packaging semiconductor dies (4) by overmolding, wherein the dies are embedded in a substrate of a mold material, and wherein cavities are produced in the mold substrate by producing 3D structures (9) of a sacrificial material prior to the overmolding step. Afterwards, the sacrificial material is removed to thereby create cavities in the mold substrate. According to the invention, 3D structures (8) of a non-sacrificial material are produced which are in contact with the sacrificial structures (9) and which are embedded in the mold substrate together with the sacrificial structures. After removal of the sacrificial structures, complex cavity shapes can thereby be created.

## Description

### Field of the Invention

The present invention is related to semiconductor package processing using overmolding techniques.

### State of the art.

Overmolding has been extensively applied in semiconductor packaging. Wafer-level molding technology is used to reconstruct a wafer or panel shaped substrate, which allows for the creation of thin film package-level interconnects in a redistribution layer (RDL). This technology is known as Fan-Out Wafer Level Packaging (FO-WLP) or eWLB, embedded Wafer Level Ball Grid Array as illustrated for example in document 'Next generation eWLB packaging', Yonggang Jin et al, proceedings of Electronics Packaging Technology Conference (EPTC), 2010. Overmolding steps applied in this technology involve the application of a mold material on a wafer comprising semiconductor dies and curing the mold material, thereby embedding the dies in a solid mold substratediedie.

Document US2017/0287736 discloses a method wherein 3D structures of a sacrificial material are produced prior to the application of the mold material. The sacrificial structures may be produced by 3D printing. After curing and setting of the mold material, the sacrificial structures are removed, thus creating cavities in the mold. A problem with the latter approach is that cavities having particular shapes cannot be realized.

### Summary of the invention

The invention aims to provide a solution to the above-named problem. This solution is provided by a method as disclosed in the appended claims. The invention is related to a method for packaging semiconductor dies by overmolding, wherein the dies are embedded in a substrate of a mold material, and wherein cavities are produced in the mold substrate by producing 3D structures of a sacrificial material prior to the overmolding step. Afterwards, the sacrificial material is removed to thereby create cavities in the mold substrate. According to the invention, 3D structures of a non-sacrificial material are produced which are in contact with the sacrificial structures and which are embedded in the mold substrate together with the sacrificial structures. After removal of the sacrificial structures, complex cavity shapes can thereby be created.

The invention is in particular related to a method for packaging one or more semiconductor dies the method comprising providing a base substrate and thereafter performing one or more overmolding steps on the base substrate to produce one mold substrate or a stack of mold substrates on the base substrate, wherein one or more dies are embedded in one or more of the mold substrates, and wherein the method comprises the steps of:
- providing one or more first 3D structures formed of a sacrificial material on a surface of the base substrate,
- performing a first overmolding step, thereby embedding the 3-dimensional sacrificial structures in a first mold substrate,
- removing said one or more first 3D structures from the first mold substrate, to thereby obtain one or more cavities in the first mold substrate,
and wherein the method further comprises providing one or more second 3D structures formed of non-sacrificial material in contact with one or more of the first 3D structures, and embedding said second 3D structures in the first mold substrate together with the first 3D structures, before removing the first 3D structures.

According to an embodiment, the base substrate comprises a carrier substrate and a temporary adhesive layer on the carrier substrate.

According to an embodiment, the base substrate further comprises one or more of the semiconductor dies, said dies being removably attached to the temporary adhesive layer.

According to an embodiment, the base substrate further comprises a redistribution layer that is removably attached to the temporary adhesive layer, and one or more of the semiconductor dies, said dies being bonded to the redistribution layer.

According to an embodiment, at least a part of the first mold substrate is thinned so as to expose an upper surface of the one or more first structures, prior to the removal of said one or more first structures. The thinning step may include grinding the surface of the first mold substrate.

The method of the invention may further comprise, after the thinning step and before the step of removing the sacrificial material :
- providing at least one additional structure formed of a sacrificial material on the thinned surface, and in direct contact with an exposed upper surface of a sacrificial structure embedded in the first mold substrate,
- possibly providing at least one additional non-sacrificial structure on the thinned surface, and in direct contact with any of the additional sacrificial structures,
- performing a second overmolding step, thereby embedding the additional 3-dimensional sacrificial structure in a second mold substrate,
- possibly repeating the above steps on the second substrate and possibly on one or more subsequent mold substrates,
wherein the step of removing the sacrificial material takes place simultaneously for the first and second mold substrates and possibly subsequent mold substrates, thereby creating at least one aggregate cavity extending across the mold substrates.

According to an embodiment, the first 3D structures and/or the second 3D structures are produced by 3D printing.

The method of the invention may further comprise the step of forming a conformal layer at least on one of the first 3-dimensional structures, wherein at least a part of the first mold substrate is thinned, thereby removing the conformal layer from the upper surface of said at least one first 3-dimensional structure, and wherein the conformal layer is maintained during the step of removing the one or more first structures, so that the conformal layer covers every surface of the first mold substrate inside one or more of the cavities.

The method according to the latter embodiment may further comprise the step of forming a second conformal layer at least on one of the second 3-dimensional structures, and wherein the second conformal layer is maintained during the step of removing the one or more first structures.

### Brief description of the figures

Figures 1a to 1i illustrate a sequence of steps for producing a package in accordance with one embodiment of the invention.
Figures 2a to 2c illustrate a sequence of steps in accordance with another embodiment of the invention.
Figures 3a and 3b illustrate an embodiment involving the production of a stack of mold substrates before removing the sacrificial material.
Figures 4a to 4g illustrate the method of the invention according to an embodiment wherein the formation of conformal layers is included in the method, for obtaining a cavity with a liner on the inner surface of the cavity.
Figure 5 illustrates the method of the invention according to an embodiment, wherein a conformal layer is formed on a sacrificial structure, and not on a non-sacrificial structure.

### Detailed description of the invention

In the method of the present invention, structures of sacrificial and non-sacrificial material are combined during the production process of a semiconductor package using overmolding, in order to create cavities of complex shape, which cannot be produced using only sacrificial material. Sacrificial and non-sacrificial structures are produced which are in contact with each other, so that the removal of the sacrificial structures and the maintenance of the non-sacrificial structures results in the appearance of cavities of a specific shape.

A sacrificial material is defined within the present context as a material that can be applied on a surface during the packaging process in the form of an essentially solid 3D structure, and that can afterwards again be removed, for example by wet etching or solvent removal, after the structures have been embedded in a mold material. Removal of the sacrificial structures can take place in a manner known as such in the art, for example from the above-cited document US2017/0287736. A sacrificial material in this sense may for example be a polymer, a temporary bonding adhesive, or a metal. A non-sacrificial material is defined with respect to a particular sacrificial material and a technique for removing the latter, i.e. for a given sacrificial material and for a given technique for removing it, a non-sacrificial material is a material that can be applied during the packaging process in the form of an essentially solid 3D structure, and that is not removable by the technique in question. When the sacrificial material is a polymer that is removable by a solvent, the non-sacrificial material may for example be polychlorinated biphenyl (PCB), a photosensitive epoxy, or a metal. Another suitable non-sacrificial material to be used in combination with a solvent-removable polymer is polymethyl methacrylate (PMMA).

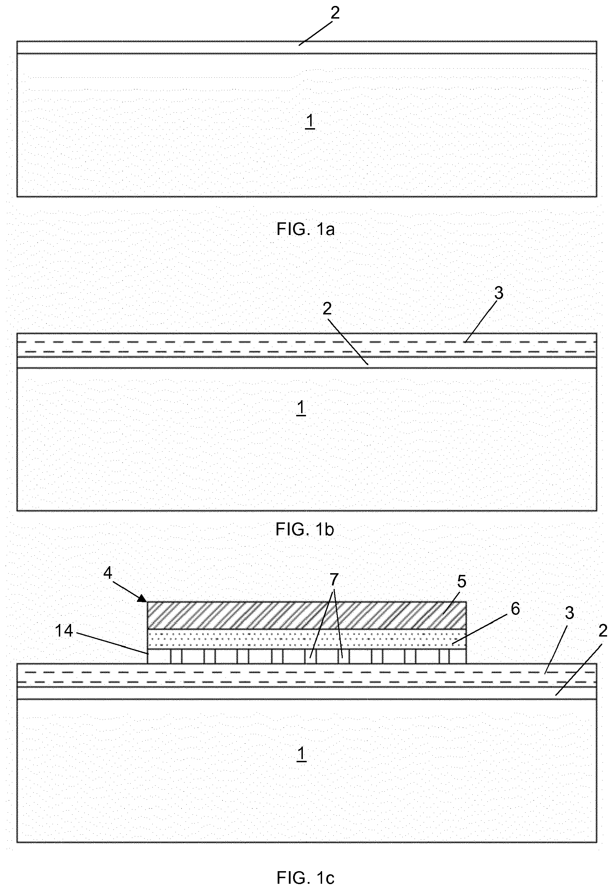

An example of a process sequence in accordance with the invention is shown in Figures 1a to 1i. Figure 1a shows a carrier substrate 1 covered with a temporary adhesive layer 2, for example a silicon or glass wafer 1 with the adhesive 2 applied thereto by soft baking or spin coating. A redistribution layer 3 (RDL) is then produced on the temporary adhesive 2 (Figure 1b). As known in the art, an RDL is a layer comprising interconnects similar to the interconnects in the back end of line of a semiconductor die. As part of a semiconductor die package, the RDL 3 connects dies to other dies within the package or to other packages. As seen in Figure 1c, a semiconductor die 4 is bonded to the RDL 3. The die 4 comprises a substrate portion 5 and an active portion 6, with solder bumps 7 on the active portion. The active portion 6 is typically formed of a front end of line part comprising active devices processed on the semiconductor substrate portion 5 and a back end of line part comprising interconnects between the active devices and the solder bumps 7. Instead of solder bumps extending outward from the surface, the die 4 may be provided with planar contact pads or other contact structures known as such in the art. The side of the bumps 7 is defined as the front side of the die 4, the opposite side is the back side of the die. The die 4 is bonded to the RDL 3 by bonding the solder bumps 7 of the die to suitable contact pads (not shown) on the upper layer of the RDL 3. A layer of underfill material 14 is applied, filling the space between the bumps 6. The underfill may be applied in any way known in the art, either during bonding of the die 3 or thereafter. The substrate 1 and temporary adhesive 2 together with the RDL and the attached die 4 represent the 'base substrate' referred to in the appended claims. The 'surface of the base substrate' may thus include a topography defined by the outer surface of dies or other fixed 3D structures attached to a plane surface which may be the surface of the temporary adhesive layer 2, or the surface of a previous mold substrate in a stack of mold substrates (see further).

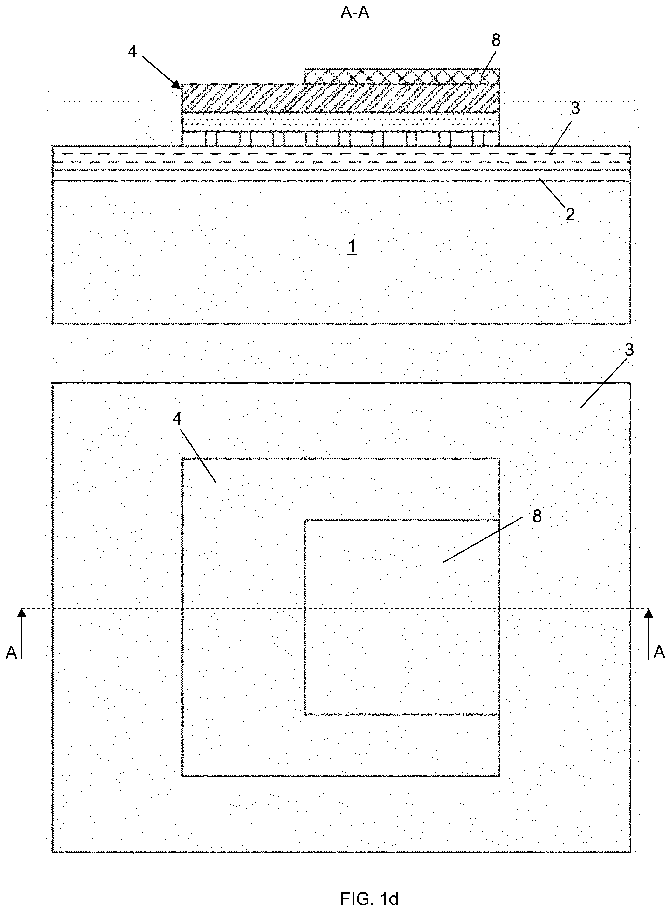

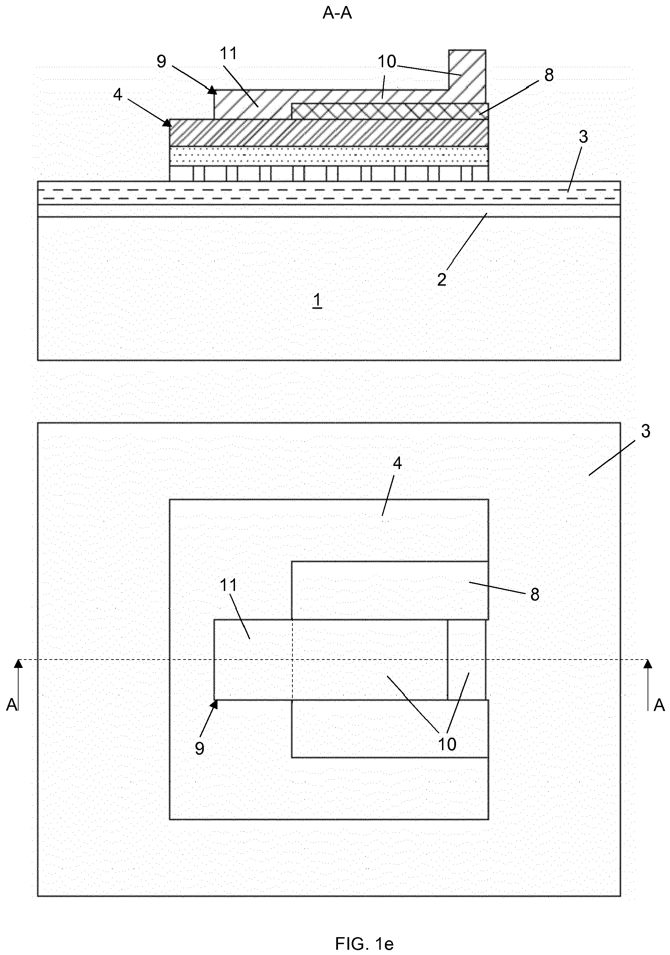

A patch 8 of a non-sacrificial material is then produced on the backside of the die, as shown in Figure 1d. The patch of non-sacrificial material may be produced by any suitable technique, for example 3D printing, stencil printing or lithography and etching. Partially above the patch 8 of non-sacrificial material, a 3-dimensional structure 9 of a sacrificial material is then produced (Fig. 1e). The structure 9 is aimed at producing a channel towards an area on the backside of the die 4, for example for cooling the die. The 3D structure 9 may for example be produced by 3D printing or any other suitable technique, such as stencil printing or lithography and etching. The specific shape of the channel requires the production of a 3D structure that includes a large overhanging portion 10 extending outward from the base 11 of the structure. As seen in Figure 1e, the overhanging portion 10 of the 3D sacrificial structure is supported by the non-sacrificial patch 8. Without this patch 8, the overhanging portion 10 of the 3D structure 9 would not be stable.

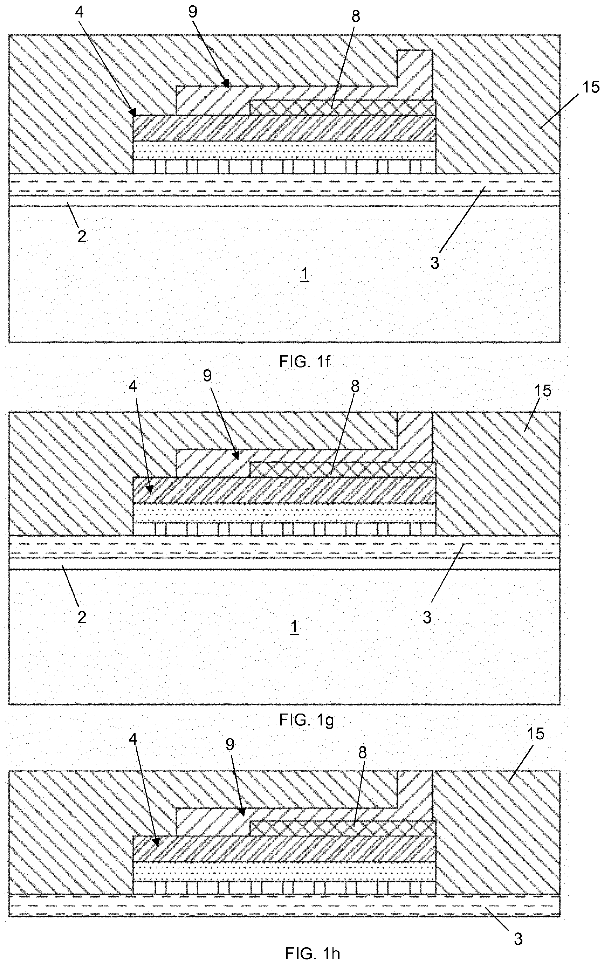

In the next step illustrated in Figure 1f, a mold substrate 15 is produced in a way that is known as such. Compression molding or transfer molding may be applied by deposition of a mold compound that is typically a mixture of particles and a thermosetting polymer, for example a thermosetting polymer with >80% silica particles. After application of the mold compound, a post-mold curing is applied to obtain a fully set mold substrate 15 embedding the die 4. The mold substrate 15 is then thinned and planarized by a suitable planarization technique such as a grinding step, as shown in Figure 1g, to a thickness wherein the upper surface of the 3D structure 9 is exposed. Possibly the thinning takes place until a thin upper layer of the structure 9 itself is removed thereby making sure that no mold material remains on the exposed surface of the structure 9. The grinding of a mold substrate is known per se, using for example a tool equipped with a rotatable grinding surface coated with a diamond powder. Other planarization techniques such as chemical mechanical polishing may be used instead of or in addition to the grinding step.

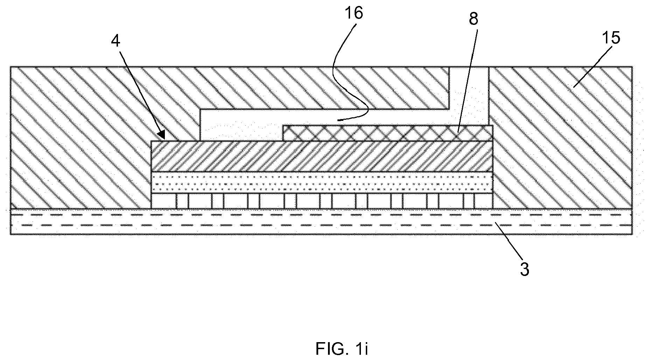

The reconstructed wafer comprising the mold substrate 15 and the RDL 3 is now released from the temporary adhesive layer 2 and thereby from the carrier substrate 1 by a debonding process known as such in the art, for example by peeling or by laser debonding (Fig. 1h). The sacrificial material 9 is then removed by a suitable technique, such as by a solvent-aided removal, or by heating and melting the sacrificial material (Fig. 1i). Removal of the sacrificial material takes place through the exposed upper surface of the structure 9. The non-sacrificial patch 8 remains. The result is a die package comprising the die 4 with a cavity 16 replacing the sacrificial structure 9. The cavity forms the desired channel 16 toward the backside of the die 4.

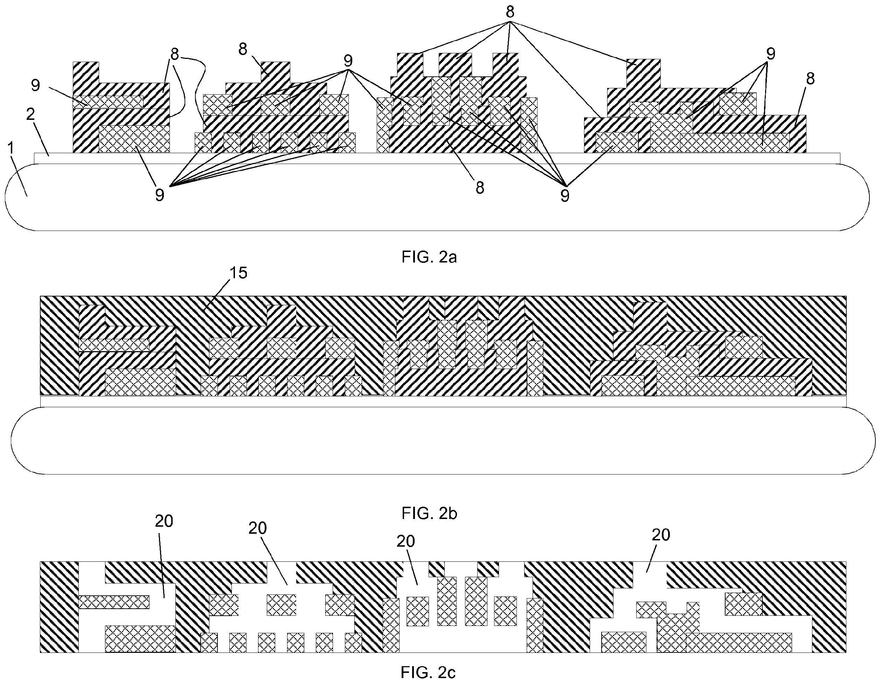

The combination of sacrificial and non-sacrificial structures in the way illustrated above is useful for the creation of all manner of complex shapes. A further example is illustrated in Figures 2a to 2c. By a succession of 3D printing steps, a variety of non-sacrificial structures 8 and sacrificial structures 9 are produced on the temporary adhesive layer 2 provided on the substrate 1 (Fig. 2a). A mold substrate 15 is then produced and thinned (Fig. 2b). Removal of the sacrificial structures results in complex cavities 20 (Fig. 2c).

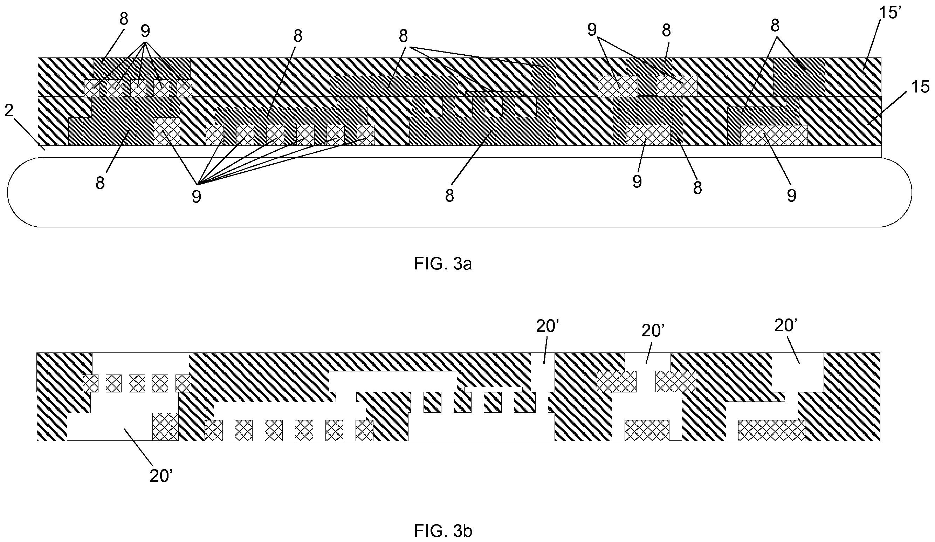

Figures 3a and 3b illustrate an embodiment wherein two consecutive overmolding steps are done before removing the non-sacrificial structures. As seen in Figure 3a, non-sacrificial structures 8 and sacrificial structures 9 are first produced by 3D printing on the adhesive layer 2, followed by overmolding and thinning for producing a first thinned mold substrate 15. Then a second series of non-sacrificial and sacrificial structures 8 and 9 are produced on the thinned mold substrate 15, followed again by overmolding and thinning to form a second mold substrate 15', stacked onto the first mold substrate 15. The removal of the sacrificial material 9 again results in aggregate cavities 20', as shown in Figure 3b. Figures 3a-3b illustrate that when multiple mold substrates are formed in a stack, it is possible to form a cavity that extends across the stack of mold substrates, provided that the sacrificial structures produced for forming this cavity are in direct contact, and that the removal of the sacrificial material takes place simultaneously for the stack of mold substrates.

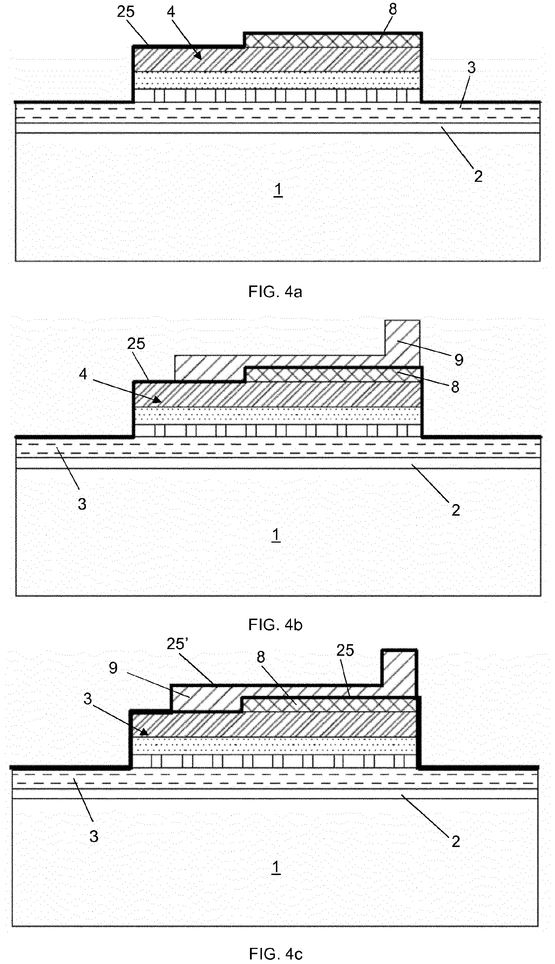

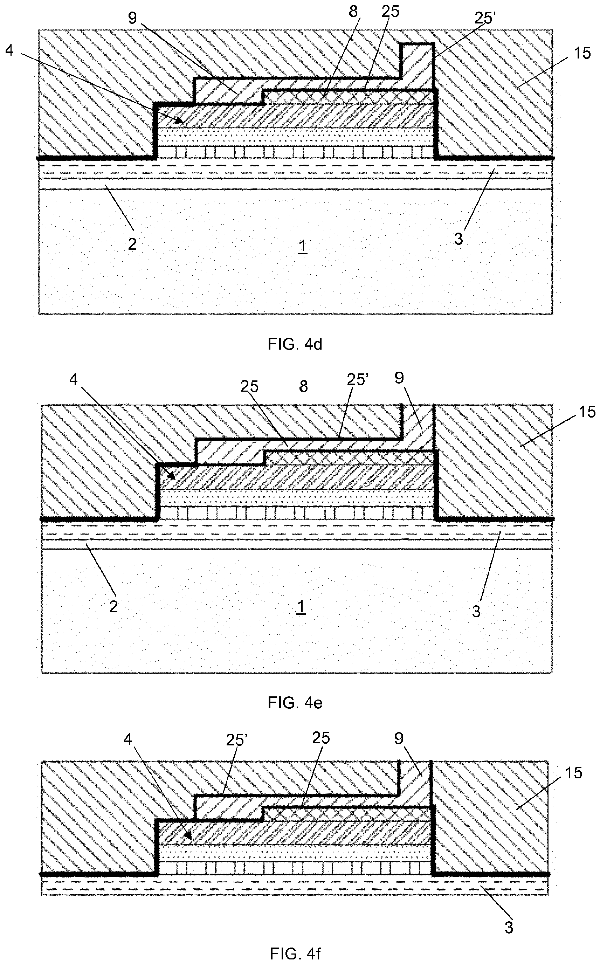

According to a particular embodiment, one or more steps of depositing a thin conformal film are added to the above-described methods, with the aim of producing a cavity that has a thin layer at least on its vertical inner walls. This embodiment is illustrated in Figures 4a to 4g, which show the process for producing the same cavity 16 as described above in relation to Figures 1a to 1i, but now including the conformal layer. As seen in Figure 4a, a conformal thin layer 25 is deposited on the topography of the base substrate, after the production of the non-sacrificial patch 8. The layer 25 is conformal in the sense that it covers every side wall and upper surface of every feature of the topography defined by the die 4 and the non-sacrificial material patch 8. The layer 25 need not be 100% conformal in terms of having the same thickness everywhere, but it must be applied so that it follows the topography, having a minimum thickness on every exposed surface, vertical (e.g. the sidewalls of the patch 8) as well as horizontal (e.g. the upper surface of the patch). In the appended claims, the layer is referred to as conformal, but it is emphasized that the interpretation of this term within the present context is as stated above. The minimum required thickness of the conformal layer 25 is preferably about 10nm.

The layer 25 may be a thin inorganic layer such as a SiO₂ layer or a Si₃N₄ layer, applied by chemical vapour deposition (CVD) or Plasma Enhanced Atomic Layer Deposition (PEALD). According to a preferred embodiment, the thin layer 25 is a moisture barrier, for example a Parylene™ layer applied at room temperature. In the context of this specification, a moisture barrier may be any material that prevents a liquid or gaseous substance, or any compound within said substance, to enter the mold substrate. The moisture barrier may furthermore prevent the material of the mold substrate or any compounds within said material to enter the cavity. The thin layer 25 is resistant to at least one removal technique for removing the sacrificial material of the structure 9 that will be produced in the next step.

This next step is illustrated in Figure 4b. The structure 9 is produced at the same location as in the first embodiment. The only difference is that now the structure 9 is produced on the conformal layer 25. Then (Fig. 4c) a second deposition of a conformal thin layer 25', preferably of the same material as the first conformal layer 25, is done, now covering the topography of the sacrificial structure 9. On the area where the layer 25 had already been deposited, layer 25' is deposited on top of said layer 25, resulting in a combined layer 25+25' of higher thickness. The combined thickness however remains in the order of tens of nanometres. Figures 4d to 4f illustrate the method steps of : overmolding to form a mold substrate 15, thinning the mold substrate 15 until an upper surface of the sacrificial structure 9 is exposed, and releasing the reconstructed wafer from the temporary adhesive 2 and thereby from the carrier substrate 1. These steps are performed in the same way as described above for the first embodiment.

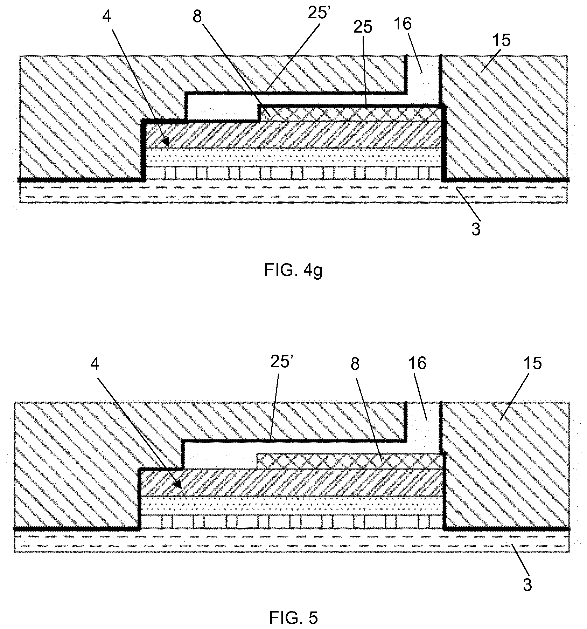

Then the sacrificial material of structure 9 is removed through the exposed upper surface thereof, the result of which is shown in Figure 4g : a cavity 16 is created defining a fluid channel from the surface of the mold substrate 15 to the die 4. As the conformal layers 25 and 25' are resistant to the removal of the sacrificial material, these layers 25 and 25' remain on the vertical side walls and on the horizontal surfaces of the cavity 16. When layers 25 and 25' are moisture barriers, the mold material and the non-sacrificial material of the patch 8 are thereby protected from contact with aggressive fluid substances passing through the cavity 16.

The number of conformal layers required in order to obtain a cavity with the conformal layer on its inner walls depends on the shapes of the sacrificial and non-sacrificial structures applied in the method of the invention, and on the number of mold substrates formed before the sacrificial material is removed. The invention is not limited to the above-described embodiment wherein two conformal layers are formed : a first layer (25) after the formation of the non-sacrificial structure 8 and a second layer (25') after the formation of the sacrificial structure 9. If a conformal layer is applied, it is at least applied after the formation of the sacrificial structure, so as to obtain the conformal layer on every surface of the mold substrate inside the cavity created after the removal of the sacrificial material. Figure 5 illustrates the cavity 16 obtained when only the conformal layer 25' is applied on the sacrificial structure 9, and no conformal layer is applied on the non-sacrificial structure 8.

A number of the above-described features are not to be understood as limitations to the scope of the invention. The conformal layer 25 may be applied only on the non-sacrificial structure 8 and not on the surrounding surface, or not on the totality of said surrounding surface. This may be required if the fluid inside the channel needs to enter into direct contact with the back side of the die 4. This may for example be the case if the die is a biochip that needs to enter into contact with a gas or liquid for analysis thereof. The conformal layer 25 could then be applied only on the patch 8 or on a limited area including the patch 8. This could be realized by depositing the layer 25 on the complete surface and then patterning the layer by lithography and etching, or by masking the area around the patch 8 before depositing the layer 25. Likewise, the second conformal layer 25' could be deposited only on the sacrificial structure 9 or on a limited area of the substrate, including said sacrificial structure.

The thinning step may be performed by other means instead of by planarization through grinding and/or CMP. The thinning could be local, performed by lithography and etching in an area comprising the sacrificial structures which are to be removed. Etching is then performed until an upper surface of such a sacrificial structure is exposed.

As already illustrated in Figures 2 and 3, the order in which sacrificial and non-sacrificial structures are produced is not fixed within the scope of the invention. Also, the number of sacrificial structures and non-sacrificial structures produced before embedding all of them in a mold substrate can be freely chosen, in accordance with the shape of the cavity that is intended to be formed after the removal of the sacrificial material.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method for packaging one or more semiconductor dies (4) the method comprising providing a base substrate and thereafter performing one or more overmolding steps on the base substrate to produce one mold substrate (15) or a stack of mold substrates (15,15') on the base substrate, wherein one or more dies are embedded in one or more of the mold substrates, and wherein the method comprises the steps of:
- providing one or more first 3D structures (9) formed of a sacrificial material on a surface of the base substrate,
- performing a first overmolding step, thereby embedding the 3-dimensional sacrificial structures (9) in a first mold substrate (15),
- removing said one or more first 3D structures (9) from the first mold substrate (15), to thereby obtain one or more cavities (16,20) in the first mold substrate (15),
and wherein the method further comprises providing one or more second 3D structures (8) formed of non-sacrificial material in contact with one or more of the first 3D structures (9), and embedding said second 3D structures (8) in the first mold substrate (15) together with the first 3D structures (9), before removing the first 3D structures (9).

2. The method according to claim 1, wherein the base substrate comprises a carrier substrate (1) and a temporary adhesive layer (2) on the carrier substrate.

3. The method according to claim 2, wherein the base substrate further comprises one or more of the semiconductor dies (4), said dies being removably attached to the temporary adhesive layer (2).

4. The method according to claim 2, wherein the base substrate further comprises a redistribution layer (3) that is removably attached to the temporary adhesive layer (2), and one or more of the semiconductor dies (4), said dies being bonded to the redistribution layer (3).

5. The method according to any one of the preceding claims, wherein at least a part of the first mold substrate (15) is thinned so as to expose an upper surface of the one or more first structures (9), prior to the removal of said one or more first structures (9).

6. The method according to claim 5, wherein the thinning step includes grinding the surface of the first mold substrate (15).

7. The method according to claim 5 or 6, further comprising, after the thinning step and before the step of removing the sacrificial material :
- providing at least one additional structure (9) formed of a sacrificial material on the thinned surface, and in direct contact with an exposed upper surface of a sacrificial structure (9) embedded in the first mold substrate (15),
- possibly providing at least one additional non-sacrificial structure (8) on the thinned surface, and in direct contact with any of the additional sacrificial structures (9),
- performing a second overmolding step, thereby embedding the additional 3-dimensional sacrificial structure (9) in a second mold substrate (15'),
- possibly repeating the above steps on the second substrate (15') and possibly on one or more subsequent mold substrates,
and wherein the step of removing the sacrificial material takes place simultaneously for the first and second mold substrates (15,15') and possibly subsequent mold substrates, thereby creating at least one aggregate cavity (20') extending across the mold substrates.

8. The method according to any one of the preceding claims, wherein the first 3D structures (9) and/or the second 3D structures (8) are produced by 3D printing.

9. The method according to any one of the preceding claims, further comprising the step of forming a conformal layer (25') at least on one of the first 3-dimensional structures (9), and wherein at least a part of the first mold substrate (15) is thinned, thereby removing the conformal layer (25') from the upper surface of said at least one first 3-dimensional structure (9), and wherein the conformal layer is maintained during the step of removing the one or more first structures (9), so that the conformal layer (25') covers every surface of the first mold substrate (15) inside one or more of the cavities.

10. The method according to claim 9, further comprising the step of forming a second conformal layer (25) at least on one of the second 3-dimensional structures (8), and wherein the second conformal layer (25) is maintained during the step of removing the one or more first structures (9).
